# EUROPEAN PATENT APPLICATION

(11) **EP 3 053 988 A2**
(43) Date of publication of application: **10.08.2016**
(21) Application number: 15168158.2
(22) Date of filing: 19.05.2015
(51) Int. Cl.: C09K 11/88, C01G 9/08, H01L 51/50

(54) **METHOD FOR FABRICATING PHOSPHOR HAVING MAXIMUM ABSORPTION WAVELENGTH BETWEEN 410 NM AND 470 NM AND HAVING NO RARE EARTH ELEMENT THEREIN AND METHOD FOR GENERATING A WHITE LIGHT BY USING THE PHOSPHOR**

(30) Priority: 09.02.2015 TW 104104303
(71) Applicant: Information Technology Inc., New Taipei City 24141 (TW)
(72) Inventor: Lin, Ching-Fuh, 10617 Taipei (TW); Shen, Pin-Chun, 10617 Taipei (TW); Tseng, Chieh-Nan, 24141 New Taipei City (TW); Chen, Kuan-Yu, 24141 New Taipei City (TW); Yang, Jhih-Siang, 24141 New Taipei City (TW)
(74) Representative: Karakatsanis, Georgios

(57) **Abstract**

The present invention relates to a method for fabricating a phosphor having a maximum absorption wavelength between 410 nm and 470 nm and having no rare earth elements therein and a method for generating a white light by using the phosphor having a maximum absorption wavelength between 410 nm and 470 nm and having no rare earth elements therein, and particularly relates to a method for fabricating manganese-doped zinc selenide nanoparticles, which can emit a yellow-orange light having a wavelength of 500 nm-700 nm, and a method for generating a white light by using the manganese-doped zinc selenide nanoparticles, which can emit a yellow-orange light having a wavelength of 500 nm-700 nm.

## Description

### CROSS REFERENCE

This application claims priority from Taiwan Patent Application No.104104303, filed February 9, 2015, the content of which are hereby incorporated by reference in their entirety for all purposes.

### BACKGROUND OF THE INVENTION

### 1. Field of the Invention

The present invention relates to a method for fabricating phosphor having a maximum absorption wavelength between 410 nm and 470 nm and having no rare earth elements therein and a method for generating a white light by using the phosphor, and particularly relates to a method for fabricating manganese-doped zinc selenide nanoparticles, which can emit a yellow-orange light having a wavelength of 500 nm-700 nm, and a method for generating a white light by using the manganese-doped zinc selenide nanoparticles, which can emit a yellow-orange light having a wavelength of 500 nm-700 nm.

### 2. Description of the Prior Art

Now, most of phosphors excited by blue light are phosphor materials containing rare earth elements. The yield of rare earth elements is few and it is difficult to mine the rare earth elements. Thus, the prices of the rare earth elements are high and still getting rising, and the costs of the phosphor and the white LED are getting increasing. Furthermore, the surface vegetation of the earth is broken when rare earth elements are mined. It results in a serious environmental disruption. The phosphor is usually fabricated by solid-state sintering. In the solid-state sintering process, the raw materials of the phosphor need to be sintered at the temperature over 1000°C for a long period of time, and hydrogen gas is necessary to be introduced for reducing the rare earth elements. It results in high cost and high risk of fabricating the phosphor. Therefore, the phosphors containing rare earth elements therein can not be widely applied, and it hinders development of white light LEDs.

For solving above-mentioned questions, finding phosphors having no rare earth elements therein is an urgent demand now. Taiwan patent "A METHOD FOR FACBRICATING METAL-ION-DOPED ZINC SULFIDE NANOPARTICLE AND A METHOD FOR GENERATING A WARM WHITW LIGHT BY USING THE METAL-ION-DOPED ZINC SULFIDE NANOPARTICLE, Taiwan application number 102112135, filed in April 3, 2013, is a patent for satisfying this demand, which is submitted by Dr. Lin who is one of inventors of this invention. In this Taiwan patent, a method for fabricating manganese-doped zinc sulfide nanoparticles (or quantum dots) by solution method is provided and disclosed, and the manganese-doped zinc sulfide nanoparticles are used instead of conventional phosphors containing rare earth elements for resolving above-mentioned problems. Therefore, the patent provides a wider development of the white light LED. However, UV is necessary for exciting the manganese-doped zinc sulfide nanoparticles (or quantum dots) to emit light because the best absorption wavelengths of the manganese-doped zinc sulfide nanoparticles (or quantum dots) are in range of the wavelengths of UV (<400 nm). Thus, the manganese-doped zinc sulfide nanoparticles (or quantum dots) can not be applied instead of the phosphors, which are excited by blue light, in the white light LED using blue light as light source. It means that the manganese-doped zinc sulfide nanoparticles (or quantum dots) are not helpful for the development of the white light LED using blue light as light source.

Furthermore, although the method for fabricating manganese-doped zinc sulfide nanoparticles (or quantum dots) has no need of the rare earth elements and the process of this method is simpler, but this method is not valid for controlling size of the manganese-doped zinc sulfide nanoparticles, overcoming the problem of aggregation of the manganese-doped zinc sulfide nanoparticles, and preventing oxidization of the manganese-doped zinc sulfide nanoparticles. Therefore, the method has characteristics of difficult size control, aggregation, and easily being oxidized of the manganese-doped zinc sulfide nanoparticles. When the manganese-doped zinc sulfide nanoparticles are applied to UV excited LED (means the LED need to be excited by UV light), these characteristics will not become disadvantages of manganese-doped zinc sulfide nanoparticles and the UV excited LED will not suffer from these disadvantages. However, when the manganese-doped zinc sulfide nanoparticles are applied to blue light excited LED (means the LED need to be excited by blue light), these characteristics will become disadvantages of manganese-doped zinc sulfide nanoparticles and the blue light excited LED will suffer from these disadvantages. It results restrictions of application and development of the manganese-doped zinc sulfide nanoparticles in white light LED field.

For solving above-mentioned problems of tranditional phosphors excited by blue light, the technology of applying manganese-doped zinc selenide nanoparticles (or quantum dots), such as ZnSe:Mn, instead of the traditional phosphors made of rare earth elements for fabricating the white light LED is developed in recent years. The manganese-doped zinc selenide nanoparticles (or quantum dots) are mostly synthesized by doped nucleation method (or process). The doped nucleation process usually uses TOP, TBP, HAD, ODE, or ODA as a reaction solvent and uses metal organic compounds as sources of metal ions. In the doped nucleation process, a precursor solution of manganese (Mn) ions is added into a precursor solution of selenium (Se) ions. The precursor solution of selenium (Se) ions is usually a precursor solution of Se-TBP, Se-TOP, Se-ODE, or phosphine ligands. The precursor solutions of Se-TBP, Se-TOP, Se-ODE, or phosphine ligands are toxic and environmentally unfriendly, and it usually results in high cost of the doped nucleation process. After, a precursor solution of znic (Zn) ions is added into the precursor solution of selenium (Se) ions. Most of the precursors (solution) of the metal ions (such as Mn, Se, and Zn) are expensive and the solvents for preparing the precursor solutions are expensive, too. Therefore, the cost of the doped nucleation process for synthesizing the manganese-doped zinc selenide nanoparticles (or quantum dots) is high. Besides, the process and the processing conditions (or requirements) of the traditional method (doped nucleation method) for synthesizing the manganese-doped zinc selenide nanoparticles (or quantum dots) are complicated because the tradition method needs two steps and high temperature (about 300°C) for growing MnSe and ZnSe. Furthermore, the manganese-doped zinc selenide nanoparticles (or quantum dots) synthesized by the traditional method (doped nucleation method) have bad dispersivity so the manganese-doped zinc selenide nanoparticles (or quantum dots) have low luminous efficiency. The manganese-doped zinc selenide nanoparticles (or quantum dots) synthesized by the traditional method (doped nucleation method) have a best absorption wavelength between UV radiation spectrum (<410 nm). Therefore, the manganese-doped zinc selenide nanoparticles (or quantum dots) synthesized by the traditional method (doped nucleation method) can not be applied instead of phosphor excited by blue light to form the white light LED which uses a blue light as light source. It means that the manganese-doped zinc selenide nanoparticles (or quantum dots) synthesized by the traditional method (doped nucleation method) are not helpful to development of the white light LED using a blue light as light source.

Most of the white light generated by the white light LEDs composed of a blue light LED and phosphor(s), which is excited by the blue light and contain rare earth elements, for example a white light LEDs composed of YAG and a blue light LED, is a cool white light having high color temperature. The cool white light with high color temperature contains a lot of blue light but lacks for the emission spectrum of the red light. Therefore, the white light have low color rendering index (CRI) because the emission spectrum of the white light lacks for the emission spectrum of the red light. If human exposes under the cool white light having high color temperature, the Melatonon secretion of human body at night will be inhibited. It results in insomnia, increasing risk of cancer, and so on. Therefore, obviously, the white light generated by these white light LEDs is not suitable for daily illumination.

Therefore, it has a need of a method for fabricating phosphor having a maximum absorption wavelength between emission spectrum of the blue light (410 nm-470 nm) and having no rare earth elements therein. In this method, other material, which is cheap, easy to be obtained, and environmentally friendly, is used instead of the rare earth elements, expensive metal organic compounds, and reaction solvents for fabricating phosphor. In this method, the phosphor can be fabricated by simple process with low cost. Furthermore, it has a need of a method for generating a white light by using the phosphor, which has a maximum absorption wavelength between emission spectrum of the blue light (410 nm-470 nm) and has no rare earth elements therein. In this method, a white light, which has low color temperature and is suitable for daily illumination, can be provided.

### SUMMARY OF THE INVENTION

In view of the foregoing, one object of the present invention is to provide a method for fabricating phosphor having a maximum absorption wavelength between 410 nm and 470 nm and having no rare earth elements therein. In this method, other materials, which are cheap, easy to be obtained, and environmentally friendly, are used to form manganese-doped zinc selenide nanoparticles (or the phosphor), and the process having advantages of simple process, simple processing conditions (or requirements) and low cost is applied to form the manganese-doped zinc selenide nanoparticles (or the phosphor). The manganese-doped zinc selenide nanoparticles have no rare earth elements, and the manganese-doped zinc selenide nanoparticles can emit a yellow-orange light having a wavelength of 500 nm-700 nm when they are excited by a blue light. The manganese-doped zinc selenide nanoparticles (or phosphors) are used instead of the conventional phosphors which are made of rare earth elements and formed by the convention solid-state sintering having a need of high cost, long processing time, and high temperature, the manganese-doped zinc sulfide nanoparticles having a maximum absorption wavelength in range of the UV spectrum, or manganese-doped zinc selenide nanoparticles (or quantum dots), which are synthesized by doped nucleation method (or process) and has a maximum absorption wavelength in range of the UV spectrum, to form the phosphors excited by blue light. Therefore, the cost of fabricating the phosphors excited by blue light can be decreased and the process of fabricating the phosphors excited by blue light can be simplified. Besides, the manganese-doped zinc selenide nanoparticles fabricated by this method can have maximum absorption wavelength suitable to be excited by a blue light, and the problems of difficult size control, aggregation, easily being oxidized, bad dispersion, and bad luminous efficiency of the manganese-doped zinc selenide nanoparticles can be improved and solved by this method. Furthermore, the phosphor fabricated by this method, which has a maximum absorption wavelength between 410 nm and 470 nm and has no rare earth elements therein, can be applied to generate a white light for providing a white light which is suitable for daily illumination and has a low color temperature.

Another object of the present invention is to provide a method for generating a white light by using the phosphor having a maximum absorption wavelength between 410 nm and 470 nm and having no rare earth elements therein. In this method, an organic fluorescent material, which can emit a green light or an orange light when it is excited by a blue light, and the phosphor, which has a maximum absorption wavelength between 410 nm and 470 nm and has no rare earth elements therein, are applied to form a white light fluorescent solution or a white light fluorescent thin film, and the process having advantages of simple process, simple processing conditions (or requirements) and low cost is applied to form the white light fluorescent solution or the white light fluorescent thin film. In the method, it has no need of the rare earth elements which are expensive, difficult to be obtained, and environmentally unfriendly. When the white light fluorescent solution or the white light fluorescent thin film is illuminated by a blue light, the white light fluorescent solution or the white light fluorescent thin film will generate a green light (or an orange light) and a yellow-orange light having a wavelength of 500 nm-700 nm simultaneously. And then, the green light (or an orange light) and the yellow-orange light are mixed with each other to generate a white light which is suitable for daily illumination, has a low color temperature, and does not hurt human body.

According to one of the objects above, a method for fabricating phosphor having a maximum absorption wavelength between 410 nm and 470 nm and having no rare earth elements therein, and particularly, a method for fabricating fabricating manganese-doped zinc selenide nanoparticles, which can emit a yellow-orange light having a wavelength of 500 nm-700 nm, is disclosed herein. The method comprises following steps: (1) preparing a first solution containing zinc ions and manganese ions; (2) preparing a second solution containing selenium ions; and (3) mixing the first solution with the second solution uniformly to prepare a mixed solution and growing manganese-doped zinc selenide nanoparticles in the mixed solution wherein the manganese-doped zinc selenide nanoparticles is the phosphor having a maximum absorption wavelength between 410 nm and 470 nm and having no rare earth elements therein. In this method, material, which is cheap, easy to be obtained, and environmentally friendly, is used to form the manganese-doped zinc selenide nanoparticles, and the process, which has advantages of simple process, simple processing conditions (or requirements), low cost is applied to form the manganese-doped zinc selenide nanoparticles. Furthermore, by this method, it is easy to control the size of the manganese-doped zinc selenide nanoparticles and to prevent manganese-doped zinc selenide nanoparticles from aggregation and oxidization, and it is helpful to improve the dispersion and luminous efficiency of the manganese-doped zinc selenide nanoparticles. The manganese-doped zinc selenide nanoparticles (or quantum dots) can emit a yellow-orange light having a wavelength of 500 nm-700 nm when they are excited by a blue light. The manganese-doped zinc selenide nanoparticles are used instead of the conventional phosphors, which are made of the rare earth elements and formed by the convention solid-state sintering having a need of high cost, long processing time, and high temperature, to form the phosphors excited by the blue light. Therefore, the cost of fabricating the phosphors excited by blue light can be decreased and the process of fabricating the phosphors excited by blue light can be simplified.

According to another one of the objects above, a method for generating a white light by using the phosphor having a maximum absorption wavelength between 410 nm and 470 nm and having no rare earth elements therein is disclosed herein. The method comprises following steps: (1) adding an organic fluorescent material into an organic solvent for preparing an organic fluorescent material solution; (2) adding a phosphor having a maximum absorption wavelength between 410 nm and 470 nm and having no rare earth elements therein into the organic fluorescent material solution and uniformly mixing the phosphor with the organic fluorescent material solution for preparing a mixed solution of the organic fluorescent material and the phosphor; and (3) heating the mixed solution to create boundary defects between the organic fluorescent material and the phosphor for preparing a white light fluorescent solution. In this method, an organic fluorescent material, which can emit a green light or an orange light by exciting of a blue light, and the phosphor, which has a maximum absorption wavelength between 410 nm and 470 nm and has no rare earth elements therein, are used to form the white light fluorescent solution, and the process having advantages of simple process, simple processing conditions (or requirements) and low cost is applied to form the white light fluorescent solution. Therefore, in the method, it has no need of the rare earth elements which are expensive, difficult to be obtained, and environmentally unfriendly, and a white light, which is suitable for daily illumination, has a low color temperature, and does not hurt human body, can be provided by the white light fluorescent solution.

Therefore, the present invention provides a method for fabricating phosphor having a maximum absorption wavelength between 410 nm and 470 nm and having no rare earth elements therein and a method for generating a white light by using the phosphor. In these methods, materials, which are cheap, easy to be obtained, and environmentally friendly, are used to form the phosphor, and the process having advantages of simple process, simple processing conditions (or requirements) and low cost is applied to form the phosphor. The phosphors are the manganese-doped zinc selenide nanoparticles which can emit a yellow-orange light having a wavelength of 500 nm-700 nm when they are excited by a blue light (440 nm-470 nm). The manganese-doped zinc selenide nanoparticles are used instead of the conventional phosphors, which are made of the rare earth elements and formed by the convention solid-state sintering having a need of high cost, long processing time, and high temperature, to form the phosphors excited by the blue light. Therefore, the cost of fabricating the phosphors excited by blue light can be decreased and the process of fabricating the phosphors excited by blue light can be simplified. Furthermore, in the method, an organic fluorescent material, which can emit a green light or an orange light by exciting of a blue light, and the phosphor, which has a maximum absorption wavelength between 410 nm and 470 nm and has no rare earth elements therein, are applied to form a white light fluorescent solution or a white light fluorescent thin film. When the white light fluorescent solution or the white light fluorescent thin film is illuminated and excited by a blue light, the white light fluorescent solution or the white light fluorescent thin film generate a green light (or an orange light) and a yellow-orange light having a wavelength of 500 nm-700 nm simultaneously. And the green light (or an orange light) and the yellow-orange light will be mixed with each other to generate a white light which is suitable for daily illumination, has a low color temperature, and does not hurt human body.

### BRIEF DESCRIPTION OF THE DRAWINGS

The foregoing aspects and many of the attendant advantages of this invention will become more readily appreciated as the same becomes better understood by reference to the following detailed description, when taken in conjunction with the accompanying drawings, wherein:
FIG. 1 is a flowchart illustrating a method for fabricating phosphor having a maximum absorption wavelength between 410 nm and 470 nm and having no rare earth elements therein in accordance with an embodiment of the present invention.
FIG. 2 is a flowchart illustrating a method for generating a white light by using the phosphor having a maximum absorption wavelength between 410 nm and 470 nm and having no rare earth elements therein in accordance with another embodiment of the present invention.

### DESCRIPTION OF THE PREFERRED EMBODIMENT

The detailed description of the present invention will be discussed in the following embodiments, which are not intended to limit the scope of the present invention, but can be adapted for other applications. While drawings are illustrated in details, it is appreciated that the quantity of the disclosed components may be greater or less than that disclosed, except expressly restricting the amount of the components. Although specific embodiments have been illustrated and described, it will be appreciated by those skilled in the art that various modifications may be made without departing from the scope of the present invention, which is intended to be limited solely by the appended claims.

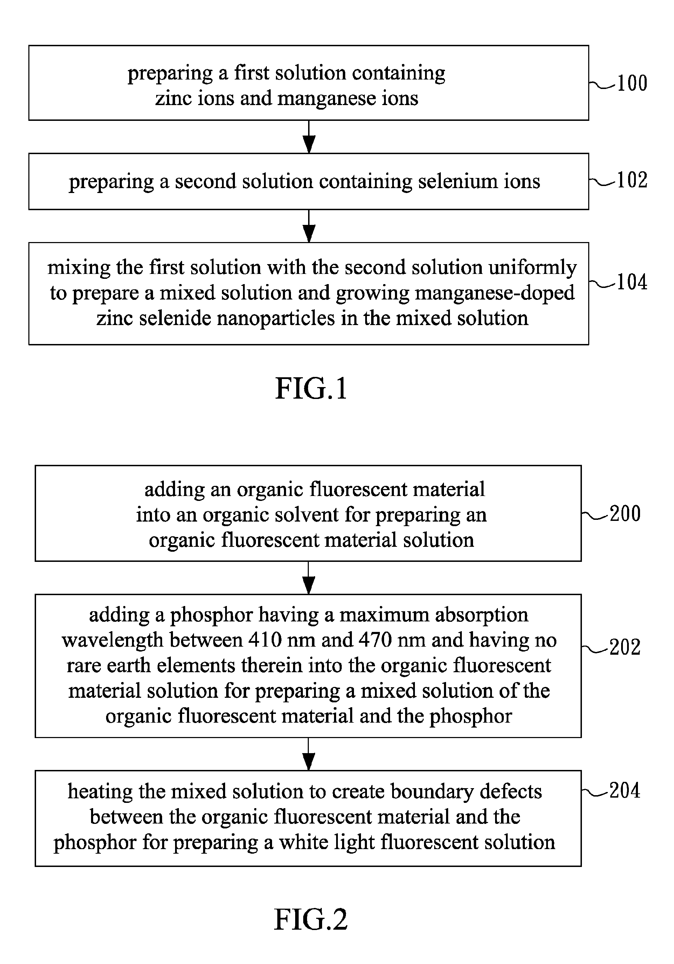

FIG. 1 is a flowchart illustrating a method for fabricating phosphor having a maximum absorption wavelength between 410 nm and 470 nm and having no rare earth elements therein in accordance with an embodiment of the present invention. Referring to FIG. 1, first, a chemical agent containing zinc and a chemical agent containing manganese are dissolved in a solvent for preparing a first solution containing zinc ions and manganese ions (step 100). In the step 100, the chemical agent containing zinc is a chemical agent capable of dissociating zinc ions by dissolution (for example be dissolved in a solvent), such as zinc nitride, zinc acetate, zinc chloride, or other chemical agent capable of dissociating zinc ions by dissolution. The chemical agent containing zinc is used as a zinc ion source of the first solution. The chemical agent containing manganese is a chemical agent capable of dissociating metal ions by dissolution (for example be dissolved in a solvent), such as manganese nitride, manganese acetate, manganese chloride" or other chemical agent capable of dissociating manganese ions by dissolution (for example be dissolved in a solvent). The chemical agent containing manganese capable of being used as a manganese ion source of the first solution. In the step 100, the solvent maybe distilled water, propanediol, methanol, ethanol, ethylene glycol, butanediol, n-butanol, acetic acid, propanetriol, butanol, xylitol, sorbitol, undecylenic acid, arachidonic acid, 2-methoxyethanol, or other solvent capable of dissolving the chemical agent containing zinc and the chemical agent containing manganese. mole ratio of the zinc ions and the manganese ions in the first solution is 1 : 0.01 to 1 : 0.30.

The step 100 further comprises an oxygen content lowering step. In the content lowering step, the first solution containing zinc ions and manganese ions is heated to 60°C-350°C for lowering the oxygen content of the first solution. Therefore, it can prevent the phosphor formed in the following steps from oxidization.

After, a chemical agent containing selenium is dissolved in a solvent for preparing a second solution containing selenium ions (step 102). In the step 102, the chemical agent containing selenium is a chemical agent capable of dissociating sulfur ions by dissolution (for example be dissolved in a solvent), such as sodium hexaselenide, aluminium selenide (Al₂Se₃), potassium selenide (K₂Se), calcium selenide (CaSe), selenium dioxide (SeO₂), sodium selenide, sodium hydrogen selenide, trioctylphosphine selenide, selenium powder + reducing agent (such as sodium borohydride, tri-n-butylphosphine (TBP), tri-n-octylphosphine (TOP), or a chemical agent capable of dissociating selenium ions by dissolution. The chemical agent containing selenium is used as a selenium ion source of the second solution. In the step 102, the solvent maybe the solvent maybe distilled water, propanediol, methanol, ethanol, ethylene glycol, butanediol, n-butanol, acetic acid, propanetriol, butanol, xylitol, sorbitol, undecylenic acid, arachidonic acid, 2-methoxyethanol, or other solvent capable of dissolving the chemical agent containing selenium.

After the step 102, the first solution, which contains zinc ions and manganese ions, and the second solution, which contains selenium ions, are uniformly mixed with each other for preparing a mixed solution, and then, manganese-doped zinc selenide nanoparticles are grown in the mixed solution (step 104). In the step 104, the mixed solution is put (or stood) at 80°C to 200 °C for 20 minutes to 24 hours for growing the manganese-doped zinc selenide nanoparticles in the mixed solution. The manganese-doped zinc selenide nanoparticles have no rare earth elements and have a maximum absorption wavelength between 410 nm and 470 nm. It means that the maximum absorption wavelength of the manganese-doped zinc selenide nanoparticles is in the range of the blue light spectrum. When the manganese-doped zinc selenide nanoparticles are excited by a blue light, the manganese-doped zinc selenide nanoparticles can emit a yellow-orange light having a wavelength of 500 nm-700 nm. The manganese-doped zinc selenide nanoparticles are the phosphors of the present invention, which have a maximum absorption wavelength between 410 nm and 470 nm and have no rare earth elements therein. In the step 104, total mole of the zinc ions and the manganese ions is 0.5-20 times more than mole of the selenium ions. By this way, the grain size of the manganese-doped zinc selenide nanoparticle can be controlled to be in range of 3 nm and 5000 nm. Therefore, the grain size of the manganese-doped zinc selenide nanoparticle can be controlled precisely in the method pf the present invention.

The step 104 further comprises a basic material addition step for adding a basic material into the mixed solution to help growing of the manganese-doped zinc selenide nanoparticles. The basic material maybe sodium hydroxide (NaOH), potassium hydroxide (KOH), calcium hydroxide, ammonia, or diaminomethanal (urea). The ratio of mole of the basic material and volume of the mixed solution is 0.1 mmol : 1 ml to 0.15 mmol : 1 ml. By the strongly alkaline property of the basic material, the mole of hydroxyl ions (OH ions) in the mixed solution can be controlled efficiently, and thereby it is helpful to precisely control the grain size of the manganese-doped zinc selenide nanoparticles having no rare earth elements and to efficiently decrease quantum confinement effect of the manganese-doped zinc selenide nanoparticles. Therefore, this step causes the difference of the maximum absorption wavelength between the manganese-doped zinc selenide nanoparticles of the present invention and the conventional manganese-doped zinc selenide nanoparticles synthesized by doped nucleation method (or process). The difference of the maximum absorption wavelength is that the the manganese-doped zinc selenide nanoparticles of the present invention have a maximum absorption wavelength between 410 nm and 470 nm (in range of the blue light spectrum) but the conventional manganese-doped zinc selenide nanoparticles synthesized by doped nucleation method have a maximum absorption wavelength shorter than 400 nm (in range of the UV spectrum).

Besides, the step 104 further comprises a metal chelating agent addition step for adding a metal chelating agent into the mixed solution to help dispersion of the manganese-doped zinc selenide nanoparticles (or the phosphor having no rare earth elements) grown in the mixed solution. Therefore, the aggregation of the manganese-doped zinc selenide nanoparticles (or the phosphor having no rare earth elements) can be avoided. The metal chelating agent maybe citric acid, trisodium citrate, calcium citrate, potassium citrate, ethylenediamine, 2,2'-Bipyridine, Phenanthroline, dimethylglyoxime, acetylacetone, auxin, glycine, DTPA, or EDTA.

Furthermore, the method for fabricating phosphor having a maximum absorption wavelength between 410 nm and 470 nm and having no rare earth elements therein maybe comprise a surface passivator addition step. In the surface passivator addition step, a surface passivator is added into the mixed solution for preventing the manganese-doped zinc selenide nanoparticles (or the phosphor having no rare earth elements) grown in the mixed solution from being oxidized. The surface passivator maybe PMMA, citric acid, trisodium citrate, calcium citrate, Trioctylphosphine oxide, Spin-on Glass (SOG), or hexadecylamine. The surface passivator addition step can be performed in the step 104, and in this surface passivator addition step, the surface passivator is directly added into the mixed solution for preventing the manganese-doped zinc selenide nanoparticles (or the phosphor having no rare earth elements). from being oxidized. Or, the surface passivator addition step can be performed after the step 104. It means that the surface passivator addition step is performed after the manganese-doped zinc selenide nanoparticles (or the phosphor having no rare earth elements) finish growing (or after the step 104 is finished). In the surface passivator addition step performed after the step 104, the surface passivator is directly mixed with the manganese-doped zinc selenide nanoparticles (or the phosphor having no rare earth elements) to cause the passivation effect on the surfaces of the manganese-doped zinc selenide nanoparticles (or the phosphor having no rare earth elements). It helps to isolate the manganese-doped zinc selenide nanoparticles (or the phosphor having no rare earth elements) from water oxygen and to resist physical attack and chemical attack.

After the manganese-doped zinc selenide nanoparticles (or the phosphor having no rare earth elements) are grown (or after the step 104 is finished), a rinsing step may be performed to the manganese-doped zinc selenide nanoparticles (or the phosphor having no rare earth elements). In this rinsing step, a cleaning agent is provided to rinse the manganese-doped zinc selenide nanoparticles (or the phosphor having no rare earth elements) for removing remained solvent to increase luminance and for preventing the manganese-doped zinc selenide nanoparticles (or the phosphor having no rare earth elements) from being oxidized by the solvent. The cleaning agent is a saturated alkane without free electron (such as hexane, isopentane, isohexane), chloroform, toluene, dichloromethane, or formic acid. Or, after the manganese-doped zinc selenide nanoparticles (or the phosphor having no rare earth elements) are grown (or after the step 104 is finished), a quickly drying step may be performed to the manganese-doped zinc selenide nanoparticles (or the phosphor having no rare earth elements). The quickly drying step is performed by low pressure dry or vacuuming to quickly vaporize remained solvent on the manganese-doped zinc selenide nanoparticles (or the phosphor having no rare earth elements) for preventing the manganese-doped zinc selenide nanoparticles (or the phosphor having no rare earth elements) from deterioration which is caused by the remained solvent on the manganese-doped zinc selenide nanoparticles (or the phosphor having no rare earth elements). In another embodiment of the present invention, after the manganese-doped zinc selenide nanoparticles (or the phosphor having no rare earth elements) are grown (or after the step 104 is finished), the rinsing step may be performed to the manganese-doped zinc selenide nanoparticles (or the phosphor having no rare earth elements) first. And then, the quickly drying step may be performed by low pressure dry or vacuuming to the rinsed manganese-doped zinc selenide nanoparticles (or the rinsed phosphor having no rare earth elements) to quickly vaporize remained solvent on the rinsed manganese-doped zinc selenide nanoparticles (or the rinsed phosphor having no rare earth elements) for preventing the rinsed manganese-doped zinc selenide nanoparticles (or the rinsed phosphor having no rare earth elements) from deterioration.

After fabrication or growing of the manganese-doped zinc selenide nanoparticles (or the phosphor having no rare earth elements) is completed, a grinding step may be performed to the manganese-doped zinc selenide nanoparticles (or the phosphor having no rare earth elements). In the grinding step, the manganese-doped zinc selenide nanoparticles (or the phosphor having no rare earth elements) are ground in order to uniformly disperse (or scatter) the manganese-doped zinc selenide nanoparticles (or the phosphor having no rare earth elements) for increasing luminance. Furthermore, after fabrication or growing of the manganese-doped zinc selenide nanoparticles (or the phosphor having no rare earth elements) is completed, a low temperature preservation step may be performed to the manganese-doped zinc selenide nanoparticles (or the phosphor having no rare earth elements). In the low temperature preservation step, the manganese-doped zinc selenide nanoparticles (or the phosphor having no rare earth elements) are preserved below 20°C for preventing the manganese-doped zinc selenide nanoparticles (or the phosphor having no rare earth elements) from deterioration.

Furthermore, the method for fabricating phosphor having a maximum absorption wavelength between 410 nm and 470 nm and having no rare earth elements therein further comprises a dispersivity and chemical stability raising step. In the dispersivity and chemical stability raising step, the manganese-doped zinc selenide nanoparticles (or the phosphor having no rare earth elements) are dipped into a solution, which can bond with surfaces of the manganese-doped zinc selenide nanoparticles (or the phosphor having no rare earth elements), or wrapped up and passivated by the solution for raising (or increasing) the dispersivity and the chemical stability of the manganese-doped zinc selenide nanoparticles (or the phosphor having no rare earth elements). The solution, which can bond with surfaces of the manganese-doped zinc selenide nanoparticles (or the phosphor having no rare earth elements), may be citric acid, trisodium citrate, calcium citrate, potassium citrate, 2,2'-bipyridine, phenanthroline, dimethylglyoxime, acetylacetone, auxin, glycine, DTPA, EDTA, trioctylphosphine oxide, hexadecylamine, PMMA, zinc nitrate, zinc acetate, zinc chloride, manganous nitrate, manganese acetate, manganous chloride, sodium chloride, potassium chloride, or other solution capable of bonding with the surfaces of the manganese-doped zinc selenide nanoparticles (or the phosphor having no rare earth elements). In one embodiment of the present invention, the dispersivity and chemical stability raising step is performed in the step (3). In the dispersivity and chemical stability raising step performed in the step (3), the surfaces of the manganese-doped zinc selenide nanoparticles (or the phosphor having no rare earth elements) are wrapped up and passivated by polyesterification of the solution, which can bond with surfaces of the manganese-doped zinc selenide nanoparticles (or the phosphor having no rare earth elements), and the solvent of the mixed solution, and thereby dispersivity and antioxidative ability of the manganese-doped zinc selenide nanoparticles are increased (or improved). Or, in another embodiment of the present invention, the dispersivity and chemical stability raising step is performed after the step (3). It means that the dispersivity and chemical stability raising step is performed after fabrication or growing of the manganese-doped zinc selenide nanoparticles (or the phosphor having no rare earth elements) is completed. In the dispersivity and chemical stability raising step performed after the step (3), the solution, which can bond with surfaces of the manganese-doped zinc selenide nanoparticles (or the phosphor having no rare earth elements), directly bond with the surfaces of the manganese-doped zinc selenide nanoparticles (or the phosphor having no rare earth elements) in order to wrap up and passivate the manganese-doped zinc selenide nanoparticles (or the phosphor having no rare earth elements). Therefore, the dispersivity and antioxidative ability of the manganese-doped zinc selenide nanoparticles are increased (or improved). The materials in the solution for wrapping up the manganese-doped zinc selenide nanoparticles may be liquid. It is helpful to mix the manganese-doped zinc selenide nanoparticles with the materials uniformly. After the manganese-doped zinc selenide nanoparticles are mixed with the materials, the mixture of the materials and the manganese-doped zinc selenide nanoparticles is dried. Therefore, the materials naturally wrap up the surfaces of the manganese-doped zinc selenide nanoparticles and the objects of passivating the manganese-doped zinc selenide nanoparticles and improving the dispersivity and antioxidative ability of the manganese-doped zinc selenide nanoparticles can be achieved.

According to foregoing embodiments, the present invention provides a method for fabricating phosphor having a maximum absorption wavelength between 410 nm and 470 nm and having no rare earth elements therein, and the phosphor can emit a yellow-orange light having a wavelength of 500 nm-700 nm when the phosphor is excited by a blue light. In this method, the chemical agent containing zinc (such as zinc nitride, zinc acetate, and zinc chloride), the chemical agent containing manganese (such as manganese nitride, manganese acetate, manganese chloride), and the chemical agent containing selenide (such as sodium hexaselenide, aluminium selenide (Al₂Se₃), potassium selenide (K₂Se), calcium selenide (CaSe), selenium dioxide (SeO₂), sodium selenide, sodium hydrogen selenide, trioctylphosphine selenide, selenium powder + reducing agent) are used for fabricating the phosphor and all of them are cheap, easy to be obtained, and environmentally friendly. Besides, in the method, it has no need of the rare earth elements, which are expensive, difficult to be obtained, and environmentally unfriendly, for fabricating the phosphor. Therefore, the cost of fabricating the phosphor can be efficiently decreased, and particularly, the cost of fabricating the phosphor excited by the blue light can be efficiently decreased. Besides, in the method, the process having advantages of low cost, simple process, simple processing conditions (or requirements), short process time, and low process temperature is applied instead of the convention solid-state sintering process having a need of high cost, long processing time, and high temperature to form the phosphor excited by the blue light. Therefore, the cost of fabricating the phosphor excited by the blue light can be decreased, and the process of of fabricating the phosphor excited by the blue light can be simplified efficiently. Accordingly, the phosphor fabricated by the method of the present invention can be applied instead of the conventional phosphor, which is fabricated by solid-state sintering process, capable of being excited by the blue light, and has rare earth elements, to be combined with a blue light LED for formin a white light LED. Therefore, the development of white light LEDs will not be hindered by the rare earth elements and the development of white light LEDs can be widened.

Besides, the phosphor fabricate by the method of the present invention can be used instead of the phosphor having a maximum absorption wavelength in range of the UV spectrum and having no rare earth elements therein, such as the manganese-doped zinc sulfide nanoparticles and the manganese-doped zinc selenide nanoparticles (or quantum dots) synthesized by doped nucleation method (or process), to be combined with a blue light LED for forming a white light LED directly. It is because the phosphor fabricate by the method of the present invention has a maximum absorption wavelength between 410 nm and 470 nm and it can emit a yellow-orange light having a wavelength of 500 nm-700 nm when the phosphor is excited by a blue light. Therefore, it has no need of combing a UV LED with the phosphor without the rare earth elements for forming the white light LED. The UV in the white light generated by the white light LED is decreased. Therefore, the white light generated by the white light LED does not hurt human body and it is suitable for daily illumination. Furthermore, in the method of the present invention, the the mole of hydroxyl ions (OH ions) in the mixed solution can be controlled efficiently by adding the basic material into the mixed solution (the basic material addition step). In the method, by efficiently controlling the mole of hydroxyl ions (OH ions) in the mixed solution and precisely controlling the growing temperature and growing time of the manganese-doped zinc selenide nanoparticles (or the phosphor having no rare earth elements), the grain size of the manganese-doped zinc selenide nanoparticles (or the phosphor having no rare earth elements) can be efficiently and precisely controlled and the quantum confinement effect of the manganese-doped zinc selenide nanoparticles can be efficiently decreased. Therefore, the manganese-doped zinc selenide nanoparticles (or the phosphor having no rare earth elements) fabricated by the method of the present invention have a maximum absorption wavelength between 410 nm and 470 nm (in range of the blue light spectrum), and it is why the manganese-doped zinc selenide nanoparticles (or the phosphor having no rare earth elements) fabricated by the method of the present invention are different from the conventional manganese-doped zinc selenide nanoparticles synthesized by doped nucleation method (or process). Besides, in the method of the present invention, the steps of adding the metal chelating agent into the mixed solution (the metal chelating agent addition step), adding the surface passivator (the surface passivator addition step), and dipping into the solution capable of bonding with surfaces of the manganese-doped zinc selenide nanoparticles (the dispersivity and chemical stability raising step) are performed for improving, raising or increasing the dispersivity of the manganese-doped zinc selenide nanoparticles (or the phosphor having no rare earth elements), for isolating the manganese-doped zinc selenide nanoparticles (or the phosphor having no rare earth elements) from water oxygen, for resisting physical attack and chemical attack, and for raising (or increasing) the luminous efficiency of the manganese-doped zinc selenide nanoparticles (or the phosphor having no rare earth elements). Therefore, the method of the present invention and the manganese-doped zinc sulfide nanoparticles fabricated by the method do not have the disadvantages of difficult size control, aggregation, easily being oxidized, low dispersivity, and low luminous efficiency, and it is why the method of the present invention is different from the conventional method (the doped nucleation method (or process)) for synthesizing the manganese-doped zinc selenide nanoparticles. Furthermore, in the method of the present invention, the hydroxyl ions (OH ions) in the mixed solution may be obtained from a hydroxyl solution combined with alkali metal. The alkali metal having bigger size is preferred. It is because the alkali metal having bigger size will not enter into the inside of the manganese-doped zinc selenide nanoparticles and it is helpful to raise the purity and the luminous efficiency of the manganese-doped zinc selenide nanoparticles.

The present invention further provides a method for generating a white light by using the phosphor having a maximum absorption wavelength between 410 nm and 470 nm and having no rare earth elements therein. FIG. 2 is a flowchart illustrating a method for generating a white light by using the phosphor having a maximum absorption wavelength between 410 nm and 470 nm and having no rare earth elements therein in accordance with another embodiment of the present invention. Referring to FIG.2, an organic fluorescent material is added into an organic solvent for preparing an organic fluorescent material solution (step 200). The organic fluorescent material can emit a green light or an orange light when the fluorescent material is excited by a blue light. The organic fluorescent material is AIQ3 [Tris-(8-hydroxyquinoline) aluminum], C545T[10-(2-Benzothiazolyl)-2,3,6,7-tetrahydro-1,1,7,7-tetramethyl-1H,5H,11H -(1)benzopyropyrano(6,7-8-l,j)quinolizin-11-one], DCJTB [4-(dicyanomethylene)-2-tert-butyl-6-(1,1,7,7-tetramethyljulolidin-4-yl-vinyl)-4h-pyran], or Ir(piq)3{ Tris[1-phenylisoquinolinato-C2,N]iridium(III)}. In the step 200, the organic solvent is toluene, chloroform, or other organic solvent capable of dissolving the foregoing organic fluorescent material.

After, a phosphor having a maximum absorption wavelength between 410 nm and 470 nm and having no rare earth elements therein is added into the organic fluorescent material solution and they are mixed with each other uniformly for preparing a mixed solution of the organic fluorescent material and the phosphor (step 202). The phosphor is a manganese-doped zinc selenide nanoparticle, and the manganese-doped zinc selenide nanoparticle is fabricated by the method illustrated in FIG.1 of the present invention. Therefore, unlike the conventional manganese-doped zinc selenide nanoparticle synthesized by the doped nucleation method (or process) has a maximum absorption wavelength in range of the UV spectrum (< 400 nm), the manganese-doped zinc selenide nanoparticle fabricated by the method illustrated in FIG.1 of the present invention has a maximum absorption wavelength in range of the blue light spectrum (410 nm to 470 nm). Due to the maximum absorption wavelength (410 nm and 470 nm) of the manganese-doped zinc selenide nanoparticle fabricated by the method illustrated in FIG.1, the manganese-doped zinc selenide nanoparticle fabricated by the method illustrated in FIG.1 can emit a yellow-orange light having a wavelength of 500 nm-700 nm when it is excited by a blue light. However, the method illustrated in FIG. 1 is detailed above so it is not mentioned herein again. In the step 202, the ratio of mole of the organic fluorescent material and volume of the mixed solution of the organic fluorescent material and the phosphor is 0.01 mmol : 1 ml to 2.0 mmol : 1 ml.

And then, the mixed solution of the organic fluorescent material and the phosphor having no rare earth elements is heated at 70°C to 250°C for 30 minutes to 90 minutes (an annealing step) for forming nano-structures between the organic fluorescent material and the phosphor having no rare earth elements in the mixed solution. These nano-structures can create or generate boundary defects (or surface defects) and surface states between the organic fluorescent material and the phosphor. The boundary defects (or surface defects) and the surface states can be uses as recombination centers electrons and electron holes and they can generate a light having the color between the color of the light generated by the organic fluorescent material and the color of the light generated by the phosphor having no rare earth elements. For example, in one embodiment of the present invention, in which Alq3 is used as the organic fluorescent material, the Alq3 emits a green light (about 530 nm), the phosphor having no rare earth elements emits a orange light (about 580 nm), and the boundary defects (or surface defects) and surface states formed in the nano-structures formed by the organic fluorescent material and the phosphor having no rare earth elements emit a light having a wavelength in range of 530 nm to 580 nm when a blue light illuminates the mixed solution of the organic fluorescent material and the phosphor having no rare earth elements. The green light emitted by the Alq3 (the organic fluorescent material, the orange light emitted by the phosphor having no rare earth elements, and the light emitted by the boundary defects (or surface defects) and surface states are mixed with each to form a white light. The light emitted or generated by the boundary defects (or surface defects) and surface states can recruit the spectrum of the white light and improve (or increase) the color rendering index (CRI) of the white light. Therefore, in this step, the mixed solution of the organic fluorescent material and the phosphor having no rare earth elements is heated for preparing a white light fluorescent solution (step 204). Furthermore, the method further comprises a step of providing a blue light source. In this step of providing a blue light source, a blue light source (such as a blue light LED) is provided to illuminate the white light fluorescent solution, and then, the white light fluorescent solution is excited to emit or generate a white light by the blue light provided by the blue light source. When the blue light (440 nm -470 nm) illuminates the white light fluorescent solution, the organic fluorescent material in the white light fluorescent solution is excited to emit a green or an orange light, the manganese-doped zinc selenide nanoparticle (or the phosphor) in the white light fluorescent solution is excited to emit a yellow-orange light having a wavelength of 500 nm-700 nm, and the boundary defects (or surface defects) and surface states formed in the nano-structures formed by the organic fluorescent material and the manganese-doped zinc selenide nanoparticle (or the surface states of the nano-structures which has high density surface energy levels (or interface energy levels) and are formed by the organic fluorescent material and the manganese-doped zinc selenide nanoparticle) emit a light having a wavelength in range of 500 nm to 650 nm. The light having a wavelength in range of 500 nm to 650 nm may be a yellow light, an orange light, or a red light. By mixing the green light (or the orange light), the yellow-orange light, and the yellow light (or the orange light or the red light) emitted by the white light fluorescent solution and the blue light emitted by the blue light source, a white light having color temperature in range of 2000K to 6000K is formed.

Furthermore, in one embodiment of the present invention, a white light fluorescent thin film is fabricated by the white light fluorescent solution first, and then, the blue light is provided to illuminate the white light fluorescent thin film for generating the white light. The method of forming the white light fluorescent thin film comprises following steps. After, a substrate is provided, and then, the white light fluorescent solution is coated on the substrate. Finally, the substrate or the white light fluorescent solution coated on the substrate is heated to remove the solvent in the white light fluorescent solution for forming the white light fluorescent thin film. And then, the white light fluorescent thin film is annealed at 70°C to 250°C for 30 minutes to 90 minutes. When the blue light provided the blue light source (such as the blue light LED) illuminates the white light fluorescent thin film, the white light fluorescent thin film is excited to emit the green light (or the orange light), the yellow-orange light having a wavelength of 500 nm-700 nm, and the yellow light (or the orange light or the red light) having a wavelength in range of 500 nm to 650 nm. And they are mixed with each other to form the white light.

In the method of the present invention for generating a white light by using the phosphor having a maximum absorption wavelength between 410 nm and 470 nm and having no rare earth elements therein, it has no need of the rare earth elements, which are expensive, difficult to be obtained, and environmentally unfriendly, and the process (such as solid-state sintering process, doped nucleation process) having advantages of high processing conditions (or requirements), complicated process, and high cost for generating a white light. It is because the organic fluorescent material, which emits the green light (or the orange light) when it is excited by the blue light, and phosphor, which has a maximum absorption wavelength between 410 nm and 470 nm and has no rare earth elements therein, are used to generate the white light. Therefore, the method has the advantages of low processing conditions (or requirements), simple process, and low cost for generating a white light. Besides, it has no need of using a UV source in the method of the present invention because the phosphor having a maximum absorption wavelength between 410 nm and 470 nm and having no rare earth elements therein is used for the white light in the method of the present invention. The UV light is more hurtful for human body than the blue light. Unlike the conventional phosphor, which is synthesized by the doped nucleation process and has no rare earth elements therein, need to use a UV light as light source, the method of the present invention uses a blue light as light source. Therefore, the white light generated by the method of the present invention is not hurtful for human body and suitable for long time illumination and daily illumination because the white light contains less UV. Comparing with the white light generated by the UV LED and the conventional phosphor which need to be excited by the UV light and has no rare earth elements therein, the white light generated by the method of the present invention has lower color temperature (2000K to 6000K).

According to foregoing embodiments, the present invention provides a method for fabricating phosphor having a maximum absorption wavelength between 410 nm and 470 nm and having no rare earth elements therein and a method for generating a white light by using the phosphor. In these methods, materials, which are cheap, easy to be obtained, and environmentally friendly, are used to form the phosphor, and the process having advantages of simple process, simple processing conditions (or requirements) and low cost is applied to form the phosphor. The phosphors are the manganese-doped zinc selenide nanoparticles which can emit a yellow-orange light having a wavelength of 500 nm-700 nm when they are excited by a blue light (440 nm-470 nm). The manganese-doped zinc selenide nanoparticles are used instead of the conventional phosphors, which are made of rare earth elements made of the rare earth elements and formed by the convention solid-state sintering having a need of high cost, long processing time, and high temperature, to form the phosphors excited by the blue light. Therefore, the cost of fabricating the phosphors excited by blue light can be decreased and the process of fabricating the phosphors excited by blue light can be simplified. Furthermore, in the method, an organic fluorescent material, which can emit a green light or an orange light by exciting of a blue light, and the phosphor, which has a maximum absorption wavelength between 410 nm and 470 nm and has no rare earth elements therein, are applied to form a white light fluorescent solution or a white light fluorescent thin film. When the white light fluorescent solution or the white light fluorescent thin film is illuminated and excited by a blue light, the white light fluorescent solution or the white light fluorescent thin film generate a green light (or an orange light) and a yellow-orange light having a wavelength of 500 nm-700 nm simultaneously. And the green light (or an orange light) and the yellow-orange light will be mixed with each other to generate a white light which is suitable for daily illumination, has a low color temperature, and does not hurt human body.

## Claims

1. A method for fabricating a phosphor having a maximum absorption wavelength between 410 nm and 470 nm and having no rare earth elements therein, comprising:
(1) preparing a first solution containing zinc ions and manganese ions wherein mole ratio of the zinc ions and the manganese ions in the first solution is 1 : 0.01-1 : 0.30;
(2) preparing a second solution containing selenium ions; and
(3) mixing the first solution with the second solution uniformly to prepare a mixed solution and growing manganese-doped zinc selenide nanoparticles in the mixed solution wherein the manganese-doped zinc selenide nanoparticles is the phosphor having a maximum absorption wavelength between 410 nm and 470 nm and having no rare earth elements therein, and total mole of the zinc ions and the manganese ions is 0.5-20 times more than mole of the selenium ions.

2. The method of claim 1, wherein in the step (1), zinc nitride, zinc acetate, zinc chloride, or a chemical agent capable of dissociating zinc ions by dissolution is dissolved in a solvent to be used as a zinc ion source of the first solution.

3. The method of claim 2, wherein in the step (1), manganese nitride, manganese acetate, manganese chloride, or a chemical agent capable of dissociating manganese ions by dissolution is dissolved in a solvent to be used as a manganese ion source of the first solution.

4. The method of claim 1, wherein the step (1) further comprises an oxygen content lowering step for heating the first solution to 60°C-350°C to lower the oxygen content of the first solution.

5. The method of claim 1, wherein in the step (2), sodium hexaselenide, aluminium selenide (Al₂Se₃), potassium selenide (K₂Se), calcium selenide (CaSe), selenium dioxide (SeO₂), sodium selenide, sodium hydrogen selenide, trioctylphosphine selenide, selenium powder + reducing agent, or a chemical agent capable of dissociating selenium ions by dissolution is dissolved in a solvent to be used as a selenium ion source of the second solution.

6. The method of claim 1, wherein the step (3) further comprises a basic material addition step for adding a basic material into the mixed solution to help growing of the manganese-doped zinc selenide nanoparticles, the basic material is sodium hydroxide (NaOH), potassium hydroxide (KOH), calcium hydroxide, ammonia, or diaminomethanal (urea), and ratio of mole of the basic material and volume of the mixed solution is 0.1 mmol : 1 ml -0.15 mmol : 1 ml.

7. The method of claim 1, wherein the step (3) further comprises a metal chelating agent addition step for adding a metal chelating agent into the mixed solution to help dispersion of the manganese-doped zinc selenide nanoparticles in the mixed solution, and the metal chelating agent is citric acid, trisodium citrate, calcium citrate, potassium citrate, ethylenediamine, 2,2'-Bipyridine, Phenanthroline, dimethylglyoxime, acetylacetone, auxin, glycine, DTPA, or EDTA.

8. The method of claim 1, further comprising a surface passivator addition step for adding a surface passivator to prevent the manganese-doped zinc selenide nanoparticles from oxidization wherein the surface passivator is PMMA, citric acid, trisodium citrate, calcium citrate, Trioctylphosphine oxide, Spin-on Glass (SOG), or hexadecylamine.

9. The method of claim 8, wherein the surface passivator addition step is performed in the step (3) in order to add the surface passivator into the mixed solution for prevent the manganese-doped zinc selenide nanoparticles from oxidization.

10. The method of claim 8, wherein the surface passivator addition step is performed after the step (3), and in the surface passivator addition step, the surface passivator is mixed with the manganese-doped zinc selenide nanoparticles directly for isolating the manganese-doped zinc selenide nanoparticles from water oxygen and for resisting physical attack and chemical attack.

11. The method of claim 1, wherein the step (3) is performed at 80°C-200°C for 20 minutes-24 hours.

12. The method of claim 1, wherein size of the manganese-doped zinc selenide nanoparticle is 3 nm to 5000 nm.

13. The method of claim 1, further comprising a rinsing step wherein in the rinsing step, a cleaning agent is provided to rinse the manganese-doped zinc selenide nanoparticles for removing remained solvent to increase luminance and for preventing the manganese-doped zinc selenide nanoparticles from being oxidized by the solvent, and the cleaning agent is a saturated alkane without free electron, chloroform, toluene, dichloromethane, or formic acid.

14. The method of claim 1, further comprising a quickly drying step wherein the quickly drying step is performed by low pressure dry or vacuuming to quickly vaporize remained solvent on the manganese-doped zinc selenide nanoparticles for preventing the manganese-doped zinc selenide nanoparticles from deterioration.

15. The method of claim 13, further comprising a quickly drying step wherein the quickly drying step is performed by low pressure dry or vacuuming to quickly vaporize remained solvent on the manganese-doped zinc selenide nanoparticles for preventing the manganese-doped zinc selenide nanoparticles from deterioration.

16. The method of claim 1, further comprising a low temperature preservation step wherein in the low temperature preservation step, the manganese-doped zinc selenide nanoparticles are preserved below 20°C for preventing the manganese-doped zinc selenide nanoparticles from deterioration.

17. The method of claim 1, further comprising a grinding step wherein in the grinding step, the manganese-doped zinc selenide nanoparticles are ground in order to uniformly disperse or scatter the manganese-doped zinc selenide nanoparticles for increasing luminance.

18. The method of claim 1, further comprising a dispersivity and chemical stability raising step wherein in the dispersivity and chemical stability raising step, the manganese-doped zinc selenide nanoparticles are dipped into a solution, which can bond with surfaces of the manganese-doped zinc selenide nanoparticles, for raising or increasing dispersivity and chemical stability of the manganese-doped zinc selenide nanoparticles, and the solution is citric acid, trisodium citrate, calcium citrate, potassium citrate, 2,2'-bipyridine, phenanthroline, dimethylglyoxime, acetylacetone, auxin, glycine, DTPA, EDTA, trioctylphosphine oxide, hexadecylamine, PMMA, zinc nitrate, zinc acetate, zinc chloride, manganous nitrate, manganese acetate, manganous chloride, sodium chloride, potassium chloride, or other solution capable of bonding with the surfaces of the manganese-doped zinc selenide nanoparticles.

19. The method of claim 18, wherein the dispersivity and chemical stability raising step is performed in the step (3), and in the dispersivity and chemical stability raising step, surfaces of the manganese-doped zinc selenide nanoparticles are wrapped up and passivated by polyesterification of the solution and the solvent of the mixed solution and thereby dispersivity and antioxidative ability of the manganese-doped zinc selenide nanoparticles are increased.

20. The method of claim 18, wherein the dispersivity and chemical stability raising step is performed after the step (3), and in the dispersivity and chemical stability raising step, the manganese-doped zinc selenide nanoparticles are wrapped up and passivated by bonding of the solution and the surfaces of manganese-doped zinc selenide nanoparticles and thereby dispersivity and antioxidative ability of the manganese-doped zinc selenide nanoparticles are increased.

21. A method for generating a white light by using a phosphor having a maximum absorption wavelength between 410 nm and 470 nm and having no rare earth elements therein, comprising:
(1) adding an organic fluorescent material into an organic solvent for preparing an organic fluorescent material solution wherein the organic fluorescent material emits a green light or an orange light when the fluorescent material is excited by a blue light;
(2) adding a phosphor having a maximum absorption wavelength between 410 nm and 470 nm and having no rare earth elements therein into the organic fluorescent material solution and uniformly mixing the phosphor with the organic fluorescent material solution for preparing a mixed solution of the organic fluorescent material and the phosphor wherein the phosphor is a manganese-doped zinc selenide nanoparticle and the phosphor emits a yellow-orange light having a wavelength of 500 nm-700 nm when the phosphor is excited by a blue light; and
(3) heating the mixed solution to create boundary defects between the organic fluorescent material and the phosphor for preparing a white light fluorescent solution.

22. The method of claim 21, wherein the organic fluorescent material is AlQ3 [Tris-(8-hydroxyquinoline)aluminum], C545T[10-(2-Benzothiazolyl)-2,3,6,7-tetrahydro-1,1,7,7-tetramethyl-1 H,5H, 11H-(1)benzopyropyrano(6,7-8-l,j)quinolizin-11-one], DCJTB [4-(dicyanomethylene)-2-tert-butyl-6-(1,1,7,7-tetramethyljulolidin-4-yl-vinyl)-4h-pyran], or Ir(piq)3{Tris[1-phenylisoquinolinato-C2,N]iridium(III)}.

23. The method of claim 21, wherein a method for the phosphor comprises:
(a) preparing a first solution containing zinc ions and manganese ions;
(b) preparing a second solution containing selenium ions; and
(c) mixing the first solution with the second solution uniformly to prepare a mixed solution of the first solution and the second solution and growing manganese-doped zinc selenide nanoparticles in the mixed solution.

24. The method of claim 21, wherein ratio of mole of the organic fluorescent material and volume of the mixed solution of the organic fluorescent material and the phosphor is 0.01 mmol : 1 ml -2.0 mmol : 1 ml.

25. The method of claim 21, wherein in the step (3), the the mixed solution is heated at 70°C to 250°C for 30 minutes to 90 minutes.

26. The method of claim 21, further comprising a step of providing a blue light source for providing a blue light source to illuminate the white light fluorescent solution wherein the white light fluorescent solution emits a white light when the white light fluorescent solution is illuminated and excited by a blue light emitted from the blue light source.

27. The method of claim 21, further comprising a step of fabricating a white light fluorescent thin film wherein the step of fabricating a white light fluorescent thin film comprises:
providing a substrate;
coating the substrate with the white light fluorescent solution; and
heating the substrate coated with the white light fluorescent solution to remove the solvent in the white light fluorescent solution for forming the white light fluorescent thin film.

28. The method of claim 27, further comprising an annealing step wherein the annealing step is performed at 70 °C to 250 °C for 30 minutes to 90 minutes.
